# EUROPEAN PATENT APPLICATION

(11) **EP 4 745 611 A1**
(43) Date of publication of application: **20.05.2026**
(21) Application number: 24212660.5
(22) Date of filing: 13.11.2024
(51) Int. Cl.: G01R 33/58, G01R 33/28

(54) **CONTROLLABLE MRI PHANTOM**

(71) Applicant: Koninklijke Philips N.V., 5656 AE Eindhoven (NL)
(72) Inventor: LEUSSLER, Christoph Günther, Eindhoven (NL)
(74) Representative: Philips Intellectual Property & Standards

(57) **Abstract**

Disclosed is a magnetic resonance imaging, MRI, phantom (100, 200, 300, 400, 500, 700), the magnetic resonance imaging phantom (100, 200, 300, 400, 500, 700) comprising: at least one phantom portion (102, 104, 106, 108, 110, 112, 604); and at least one phantom-portion specific switchable shielding portion (114, 116, 118, 120, 122, 124, 606), wherein the at least one switchable shielding portion is configured to be switchable between a blocking, resonant state and a transparent, non-resonant state respective to an MRI frequency range.

## Description

### BACKGROUND

In the field of medical imaging, particularly magnetic resonance imaging (MRI), there is a growing need for standardized and reproducible testing procedures to ensure imaging equipment delivers consistent and accurate results. This need has led to the development of specialized devices known as phantoms, which are used to simulate the interaction of human tissues and organs with MRI systems. Phantoms help in the assessment of crucial imaging parameters such as geometric distortion, resolution, slice profile, signal-to-noise ratio (SNR), proton-spin relaxation times, image uniformity, and B1 uniformity, which are essential for both imaging quality and patient safety.

Despite their usefulness, current phantoms face several limitations. One of the primary challenges is their fixed positioning. Phantoms cannot be repositioned easily once placed, nor can they be switched off during a procedure. When not needed, they must be physically removed from the patient bed, leading to workflow interruptions. Moreover, existing phantoms are characterized by a fixed loading, meaning their properties cannot be modified during MRI calibration or imaging sequences. This lack of flexibility limits their adaptability to different imaging requirements or changing calibration needs.

### SUMMARY OF THE INVENTION

It is an objective to provide for a magnetic resonance imaging, MRI, phantom, an MRI system comprising the MRI phantom, a method of operating an MRI phantom, a method for operating an MRI system and a computer program for performing any of these methods. The objectives underlying the invention are solved by the features of the independent claims.

In one aspect a magnetic resonance imaging, MRI, phantom is disclosed. The magnetic resonance imaging phantom comprises at least one phantom portion. It further comprises at least one phantom-portion specific switchable shielding portion. The at least one switchable shielding portion is configured to be switchable between a blocking, resonant state and a transparent, non-resonant state respective to an MRI frequency range.

In another aspect, a magnetic resonance imaging, MRI, system comprising the MRI phantom of any of the previous examples and/or aspects is disclosed.

In another aspect, a method of operating a magnetic resonance imaging, MRI, phantom is disclosed. The magnetic resonance imaging phantom comprises at least one phantom portion. It further comprises at least one phantom-portion specific switchable shielding portion. The at least one switchable shielding portion is configured to be switchable between a blocking, resonant state and a transparent, non-resonant state respective to an MRI frequency range. The method comprises switching the at least one phantom-portion specific switchable shielding portion in response to receiving a switching signal.

In another aspect, a method of operating the MRI system of the abovementioned aspect is disclosed. The method comprises switching the at least one phantom-portion specific switchable shielding portion to the transparent, non-resonant state. It further comprises acquiring calibration k space data by controlling the MRI system with at least one calibration pulse sequence command. The method further comprises switching the at least one phantom-portion specific switchable shielding portion to the blocking, resonant state. It further comprises acquiring imaging k space data by controlling the MRI system with at least one imaging pulse sequence command. Eventually, it comprises reconstructing an MRI image using the imaging k space data and the calibration k space data.

In another aspect, a computer program comprising machine executable instructions for execution by a computational system is disclosed. Execution of the machine executable instructions causes the computational system to perform the method of any of the previous aspects and/or examples.

It is understood, that examples and/or aspects can be combined, as long as they are not mutually exclusive. In particular, examples of the aforementioned MRI phantom and/or MRI system and/or method of operating a magnetic resonance imaging, MRI, phantom and/or method for operating the MRI system and/or computer program can be combined with any of the aforementioned aspects, as long as the combined aspects and/or examples are not mutually exclusive.

It is understood that one or more of the aforementioned examples may be combined as long as the combined examples are not mutually exclusive.

### BRIEF DESCRIPTION OF THE DRAWINGS

In the following, examples are described in greater detail making reference to the drawings in which:
Fig. 1 shows a magnetic resonance imaging, MRI, phantom,
Fig. 2 depicts the MRI phantom integrated into earplugs, a cushion and into a head coil,
Fig. 3 illustrates flexible surface coils positioned either on top of or beneath the patient's body, with the phantoms integrated into the coils,
Fig. 4 shows the phantom integrated into an MRI patient's bed,
Fig. 5 illustrates phantoms that are integrated into a harness.,
Fig. 6 shows the MRI phantom fitted into a recess of a coil,
Fig. 7 shows the MRI phantoms fitted into flexible cushions,
Fig. 8 shows a flowchart for a method for operating an MRI system, and
Fig. 9 shows an MRI system 900 comprising an MRI phantom.

### DETAILED DESCRIPTION

Herein, we describe the concept of a controllable MRI phantom that could revolutionize MRI workflows with switchable shielding portions, which may shield the actual phantom portions from an MRI system. These shielding portions may be toggled between blocking, resonant and transparent, non-resonant states, allowing the phantom to stay on the patient bed through both calibration and imaging. Such functionality could eliminate the need for physical repositioning, saving valuable time and reducing disruptions within the imaging process. For example, the shielding portions of the phantom could be set to a transparent, non-resonant state during calibration to allow free signal passage to the phantom portions for precise system adjustments and calibration. Subsequently, the shielding portions might switch to a blocking, resonant state during imaging to prevent unwanted signal interference with the phantom portions, thereby enabling optimal data acquisition.

An MRI phantom could be a device used in magnetic resonance imaging to simulate the characteristics of human tissues, e.g., allowing for testing and calibration of MRI systems without the need for human subjects. It may be made from materials that could mimic the physical and electromagnetic properties of body tissues. For example, the materials comprise rubber, gels and/or water.

This switchable nature may further enable precise, real-time adjustments to the phantom's properties, introducing significant flexibility during calibration procedures. The ability to toggle states for each shielding portion independently could allow the phantom to be fine-tuned to meet specific calibration protocol requirements, potentially leading to improved signal accuracy and reduced interference. Additionally, the individually switchable shielding portions could allow the phantom to support specialized imaging scenarios, such as multi-nuclei imaging or variable loading conditions, where high adaptability is essential. By dynamically responding to the demands of complex imaging protocols, the phantom may serve as a versatile tool, accurately simulating different tissues or anatomical conditions as required. This functionality could be coupled with automated calibration systems, enabling fully autonomous imaging and/or calibration processes that require minimal human intervention and deliver consistent, reproducible imaging results.

The integration of switchable shielding portions may also significantly improve MRI system calibration precision. By allowing the phantom to transition to a non-resonant state during calibration and a resonant state during imaging, the system could optimize signal control for each scan phase. Furthermore, the phantom's flexibility within a range of MRI frequencies may allow it to simulate various tissue types more effectively, enhancing its adaptability across diverse imaging applications.

Together, these innovations could result in more accurate images, streamlined workflows, better calibration results, automated workflows and enhanced performance of MRI systems, making the switchable phantom an invaluable asset in advancing MRI technology.

The term switchable may refer to the ability of certain parts of the phantom to transition between different states. These parts could switch between a state that blocks signals (blocking state) and a state that allows signals to pass (transparent state). For instance, a switchable phantom portion might block specific signals when it is in a resonant state and allow them to pass when it is in a non-resonant state.

A portion of the phantom might represent a specific part or segment of the device. It may be as a section that simulates a certain type of tissue or body part. Each portion could have its own switchable shielding, allowing for independent control over how each section interacts with the MRI system.

For example, the resonant state describes a condition where the switchable shielding portion responds to specific frequencies of electromagnetic waves used in MRI, potentially blocking or reflecting the signals to prevent them from passing through to the corresponding phantom portion and in terms preventing them from being captured by the MRI. For example, a non-resonant state allows the signals to pass through the switchable shielding portion without interference, making the switchable shielding portion effectively transparent to the MRI system and thus allowing the signals to pass through to the corresponding phantom portion and in terms allowing them to be captured by the MRI.

The MRI frequency range might refer to the specific frequencies at which the MRI system operates. The phantom portions and/or the at least one switchable shielding portion could be designed to work within this range. For example, the frequency range corresponds to hydrogen (¹H nuclei). The frequency range for may be governed by the Larmor equation, which could describe the relationship between the magnetic field strength and the radiofrequency (RF) signals used for imaging. For example, in a 1.5 Tesla MRI system, the frequency range for ¹H (hydrogen) might be in between 63 MHz to 64 MHz. In higher-strength systems, such as a 3 Tesla MRI machine, the frequency range for ¹H (hydrogen) could be in between 123 MHz to 130 MHz. 7 Tesla systems might operate in the frequency range for ¹H (hydrogen) of 290 MHz to 300 MHz. Lower-field systems like 0.5 Tesla may use frequencies for ¹H (hydrogen) between 21 MHz and 22 MHz. Thus, the MRI frequency range for ¹H (hydrogen) may be in between 15 MHz to 315 MHz, in particular in between 20 MHz to 301 MHz, in particular in between 21 Mhz to 300 Mhz.

For example, the at least one phantom-portion specific switchable shielding portion is configured to be switched between the blocking, resonant state and the transparent, non-resonant state by a control circuit. The control circuit is either integrated into the MRI phantom or an external control circuit.

In one example, the blocking, resonant state blocks the provision of signal data from the at least one phantom portion to an MRI system, whereas the transparent, non-resonant state allows the provision of signal data from the at least one phantom portion to the MRI system.

A control circuit in the MRI phantom could regulate the switching of shielding portions between blocking and transparent states. This circuit might thus act as a detune circuit, with a drive circuit generating a gate voltage to activate the switching. The drive circuit may receive a digital control signal (e.g., TTL) or an optical control signal via fiber optics.

An external control circuit could reside outside the phantom, sending the necessary signals for switching. For example, the MRI system itself might provide these switching signals to operate the detune electronics, which could include switches to electronically manage the shielding.

Advantages of such a system could include precise, automated switching, reducing manual adjustments and ensuring efficient operation during complex imaging sequences. An integrated control circuit might offer faster response times, while an external one could allow centralized control over multiple devices in larger systems.

For example, in case the control circuit is integrated into the MRI phantom, the MRI phantom further comprises a battery and/or electronics for energy harvesting, in particular electronics for inductive energy harvesting. The battery and/or electronics for energy harvesting are configured to power the control circuit. In case the control circuit is integrated into the MRI phantom, the control circuit further comprises means for wireless communication, which are configured to receive signals for switching the at least one phantom-portion specific switchable shielding portion and/or send information about a switching state of the at least one phantom-portion specific switchable shielding portion.

For example, the electronics for energy harvesting charge the battery. For example, electronics for energy harvesting refer to systems within the MRI phantom that capture and/or store energy from external sources, such as electromagnetic fields, particularly through inductive energy harvesting. This might allow the phantom to power its internal electronics, including the control circuit, using e.g., the magnetic field from the MRI machine itself and/or other magnetic fields. For example, the phantom could continuously operate within the MRI system without requiring frequent battery replacements.

Means for wireless communication may not need to involve high-latency protocols. For example, Bluetooth, Wi-Fi (2.4 GHz, 5 GHz, or 6 GHz), 868 MHz, or 433 MHz communication might allow the phantom to receive commands for switching shielding portions or send updates about its status.

One advantage could be that the phantom may become less dependent on external power sources, using energy harvesting to power itself indefinitely, thereby reducing the need for frequent battery replacements or recharging. This self-sustainability might also minimize the need for manual intervention, allowing the phantom to remain in the MRI environment without interruption. Additionally, using low-latency wireless communication could provide more flexibility in controlling the phantom, allowing real-time adjustments without physical connections, making it easier to integrate the phantom into automated or remote-controlled MRI systems. The phantom maybe a full autonomous external device, that may be left in place without the need for service or adjustment.

For example, the MRI phantom comprises at least two of the phantom portions. It further comprises at least two of the phantom-portion specific switchable shielding portions. The at least two phantom-portion specific switchable shielding portions are configured to be switchable independently from each other.

In one example, the at least two phantom portions have different resonant frequency ranges. Individually switchable phantom portions may provide the advantage of flexibility in both frequency and location. Each portion could be tailored to specific resonant frequencies and might be positioned at different locations within the MRI system, allowing for precise control over signal acquisition. For example, different portions could be activated or deactivated based on their spatial location or the imaging frequency, ensuring that only the relevant portions contribute to the scan and/or the calibration procedure. This might reduce interference and enhance imaging quality, especially in complex or multi-phase imaging and/or calibration scenarios, where different parts of the phantom are required to represent various tissues or conditions. Additionally, this could improve calibration accuracy by enabling the system to target specific regions or frequencies as needed, without affecting other portions of the phantom.

For example, the MRI phantom further comprises at least one sensor, in particular at least one temperature sensor.

For example, a temperature sensor might monitor the internal or external temperature of the phantom. It may ensure that the phantom's materials do not overheat and affect the accuracy of the imaging results. This may help prevent distortion caused by thermal expansion or changes in the physical properties of the phantom materials. Furthermore, the sensor could allow for real-time feedback on temperature fluctuations, which might be crucial in high-field MRI systems where heating effects are more pronounced. By providing constant monitoring, the temperature sensor may improve the reliability and consistency of the phantom during repeated or prolonged use, ensuring more accurate and reproducible imaging results across different conditions.

For example, the MRI phantom further comprises switches configured to switch the at least one phantom-portion specific switchable shielding portion. The switches comprise any one of the following: Gallium Nitride Field-Effect Transistors, GaN-FETs, diodes, in particular positive intrinsic negative diodes, Field-Effect Transistors, FETs, and/or Micro-Electro-Mechanical-Systems, MEMs.

Gallium Nitride Field-Effect Transistors (GaN-FETs) could be semiconductor devices known for their high efficiency and ability to operate at high frequencies and temperatures. These transistors may be used to switch the phantom's shielding portions rapidly and with minimal power loss. For example, GaN-FETs might be preferred in MRI systems due to their low resistance and fast switching speed, which may improve signal accuracy.

Diodes, particularly positive intrinsic negative (PIN) diodes, could be components that control the flow of electrical current. In MRI applications, PIN diodes might be used for switching or tuning circuits, as they may quickly alternate between conducting and non-conducting states, depending on the control signals.

Field-Effect Transistors (FETs) may be transistors that control current flow through an electric field. These could be used to manage the switching of shielding portions, allowing precise control over the phantom's interaction with the MRI system.

Micro-Electro-Mechanical Systems (MEMs) could refer to tiny mechanical devices that may be integrated into electronic systems to switch or control shielding portions. MEMs might provide high precision and reliability in switching mechanisms within confined spaces.

Here, an electronic switch may be used to switch the network on and off, with the on impedance ranging from 50 to 500 milliohms and the off impedance between 5 to 10 kilo-ohms. Preferably, GaN FETs are used as switches, which are controlled by the MRI scanner or host computer. The gate of the switch could receive an on/off voltage, causing the Source Drain to act as a switch with high and low impedance.

For example, the phantom is transparent across frequencies of multiple nuclei and/or nuclear magnetic resonance (NMR) isotopes. This may be necessary in clinical applications, wherein the clinical applications may comprise spectroscopy and/or magnetic resonance spectroscopy. For example, the nuclei and/or nuclear magnetic resonance (NMR) isotopes comprise ¹H (hydrogen), ³He (helium-3), ¹³C (carbon-13), ²³Na (sodium-23), and/or ³¹P (phosphorus-31). To achieve transparency at multiple frequencies, the control circuit could be configured to maintain a high impedance at more than one frequency. High impedance levels may be defined as between 5 kilo-ohms and 10 kilo-ohms in the off-state of the switch. Alternatively, the control circuit might operate as a broadband switch covering the frequency ranges between 50 milliohms to 10 kilo-ohms, thus accommodating the varied frequency requirements of multi-nuclei imaging and spectroscopy applications.

In the case of a switchable RF shield around the phantom, multiple switches might be employed to individually control the different meshes of the shield. A mesh may be a different term for a switchable shielding portion. Each switch could independently turn specific meshes on or off, allowing for precise control over the RF shielding during the MRI scan.

The advantages of using GaN FETs and these switching mechanisms may include faster switching speeds, lower power consumption, and higher thermal efficiency, which could enhance the performance of the phantom. The ability to manage individual meshes in the RF shield may provide greater flexibility, enabling the phantom to better adapt to different imaging conditions, thus improving signal control and imaging accuracy.

For example, the phantom further comprises a mounting mechanism configured to mount the phantom at a specific location relative to a magnetic resonance imaging system.

A mounting mechanism could provide several advantages for the MRI phantom. It might ensure that the phantom is positioned accurately and consistently in relation to the MRI system, improving the reproducibility of imaging results. For example, by securing the phantom at a specific location, the system could reduce variability in scans, leading to more reliable calibration and testing. Additionally, a stable mounting system may allow the phantom to remain fixed during long procedures, minimizing movement and potential disruptions in the imaging process.

For example, the MRI phantom is integrated into a cushion configured to support a body or a portion of a body of patient to be imaged by an MRI system, and/or wherein the MRI phantom is integrated into earplugs and/or a harness configured to be worn by a patient to be imaged by an MRI system and/or the MRI phantom is integrated into a therapy device, wherein in particular the therapy device is any one of the following: an oncology device, a radiactive seed, an electromagnetic or optical therapy unit, wherein the oncology device comprises any one of the following: a Linear Accelerator, Linac, a Brachytherapy Applicator, a Proton Therapy System, an MRI-Guided Focused Ultrasound Therapy device, MRgFUS, a Theranostic System, an Interventional Oncology device.

A cushion may refer to a soft support designed to comfortably position a patient or a specific part of the body during an MRI scan. Earplugs could be devices inserted into the ears to block noise or stabilize the head, while a harness may be a wearable support system that holds the body or specific body parts in place during imaging.

The advantage of integrating the MRI phantom into these elements might be that it allows for simultaneous calibration and patient imaging, ensuring the phantom is precisely aligned with the patient's position. This setup could reduce the need for separate calibration steps, improving workflow efficiency and enhancing the accuracy of patient-specific imaging data. Additionally, it may ensure patient comfort while enabling precise measurements during the MRI scan.

For example, the MRI phantom is integrated into a head coil, a surface coil, a body coil and/or a bed-integrated surface coil of the MRI system.

A head coil may be a specialized MRI coil used for high-resolution brain imaging, surrounding the patient's head to capture detailed scans. Integrating the phantom into the head coil could allow for real-time calibration, ensuring precise brain imaging during the scan. A surface coil could be a smaller coil placed near the body for localized imaging, such as of the knee or spine. Incorporating a phantom into a surface coil might improve calibration accuracy for specific body parts. A bed-integrated surface coil might be built into the MRI table for larger area scans, such as the torso. Integrating the phantom into this coil could enable continuous calibration during extended scans. The advantage across all these scenarios may be real-time calibration, improving image accuracy and workflow efficiency.

A body coil may also be used to integrate a phantom. Body coils may be located around larger parts of the body. The larger parts of the body may comprise a torso, abdomen, pelvis, and/or chest. They may function as either receive-only or transmit/receive coils. By incorporating switchable phantoms, body coils may facilitate calibration for the larger parts of the body. Additionally, system-integrated coils, including body coils, could support the integration of phantoms to provide flexible, large-scale calibration options within MRI systems.

For example, at least one coil of the MRI system comprises a recess configured to accommodate the MRI phantom, such that the MRI phantom can be inserted into or removed from the recess.

A recess may refer to a specifically designed cavity or slot in an MRI coil that is shaped to securely fit the MRI phantom. This design could allow the phantom to be easily inserted or removed, making it a plug-and-play unit. For example, the phantom might be quickly placed into the same location each time without requiring manual adjustments, ensuring consistency in positioning for accurate calibration.

The recess might allow the phantom to be used in various coils, ensuring that it is always aligned correctly with the imaging system. This could streamline the workflow by enabling easy insertion and removal, reducing setup time and minimizing errors in positioning. Additionally, the fixed location provided by the recess may enhance reproducibility in imaging results, as the phantom could always be placed in the exact same spot. This may lead to more consistent calibration and higher imaging accuracy during repeated procedures.

For example, the switching signal is received from an MRI system.

Receiving the switching signal from the MRI system could offer several key advantages. First, it may ensure perfect synchronization between the MRI system and the phantom's switchable shielding portions. By having the MRI system control the switching, the phantom could automatically adjust between its resonant and non-resonant states at exactly the right moments, ensuring optimal calibration and signal accuracy during scans.

Additionally, this setup might reduce the need for separate control devices, simplifying the system by allowing the MRI machine to handle both scanning and phantom control. This could lead to a more streamlined and automated workflow, minimizing human intervention and potential errors. Furthermore, since the MRI system knows its operating frequencies and scan phases in real time, it could make the switching of the phantom's shielding highly efficient, responding instantly to the needs of different imaging sequences, which might improve overall imaging quality and consistency.

k space could refer to a mathematical representation used in MRI to store raw data before reconstructing an image. It might not represent an image directly but instead contains information about spatial frequencies that are later transformed into an image using algorithms like Fourier transformations. For example, when MRI data is collected, it is first stored in k space, and only after processing does it become a readable MRI image.

In the method described, calibration k space data might be acquired to ensure that the MRI system is properly calibrated, while imaging k space data could represent the actual information needed to create the final MRI image. By using both calibration and imaging k space data, the system may achieve greater accuracy and image quality. The method might further comprise reconstructing at least two calibration images from the calibration k space data and then using the at least two calibration images during the reconstruction of the MRI image.

One advantage could be that by acquiring calibration k space data with the phantom in the non-resonant state, the MRI system may ensure optimal calibration without interference, leading to more accurate adjustments. Then, switching the phantom to the resonant state during the actual imaging allows the system to focus entirely on capturing patient-specific data without being affected by the phantom.

This approach could enhance the precision of both calibration and imaging by separating these processes, allowing each to be optimized independently. The method might also lead to improved image quality, as the system would be properly calibrated before acquiring the final imaging data. Additionally, by synchronizing the phantom's states with the MRI system's commands, the entire process could become more streamlined and automated, reducing manual intervention and the risk of errors during the scanning procedure.

In the following, similar elements are denoted by the same reference numerals.

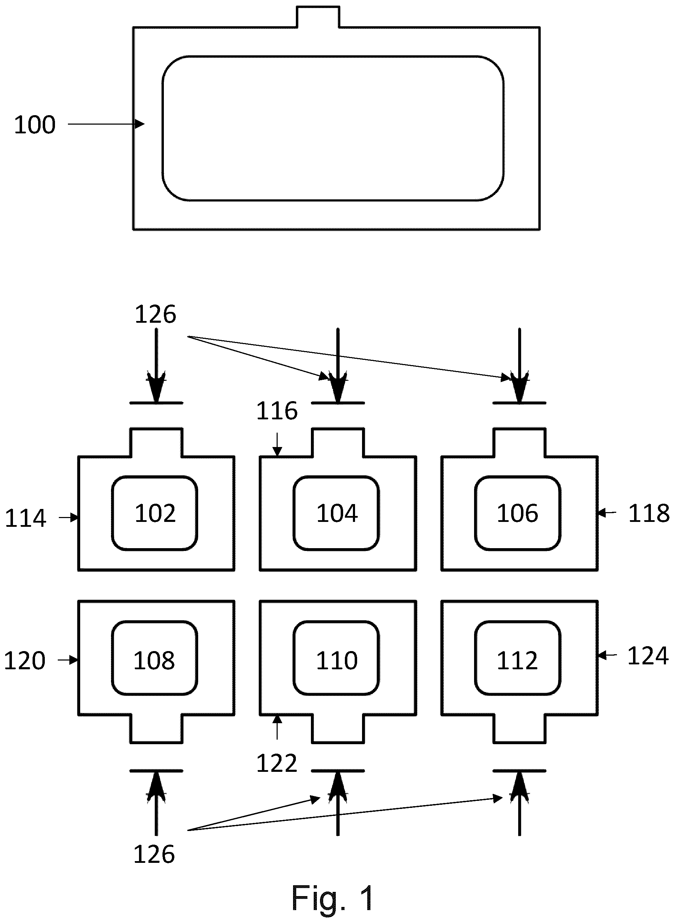

Fig. 1 shows a magnetic resonance imaging, MRI, phantom 100.

In Fig. 1, the MRI phantom 100 in the upper half of 1 comprises at least one phantom portion and one switchable shielding portion. The MRI phantom 100 of Fig. 1 in the upper half part of Fig. 1 may also comprise more than one phantom portion and more than one switchable shielding portion. An example outlining this is shown in the lower part of Fig. 1. The phantom in the lower part of Fig. 1 may be a detailed view of the MRI phantom 100 in the upper part of Fig. 1. The lower part of Fig. 1 illustrates the MRI phantom 100 with 6 individual phantom portions 102, 104, 106, 108, 110 and 112. It may further comprise 6 switchable shielding portions 114, 116, 118, 120, 122 and 124, each one of these corresponding to the 6 individual phantom portions 102, 104, 106, 108, 110 and 112. The switchable shielding portions in the example phantom 100 of Fig. 1 are configured to be switchable independently from each other and configured to be switchable between a blocking, resonant state and a transparent, non-resonant state respective to an MRI frequency range.

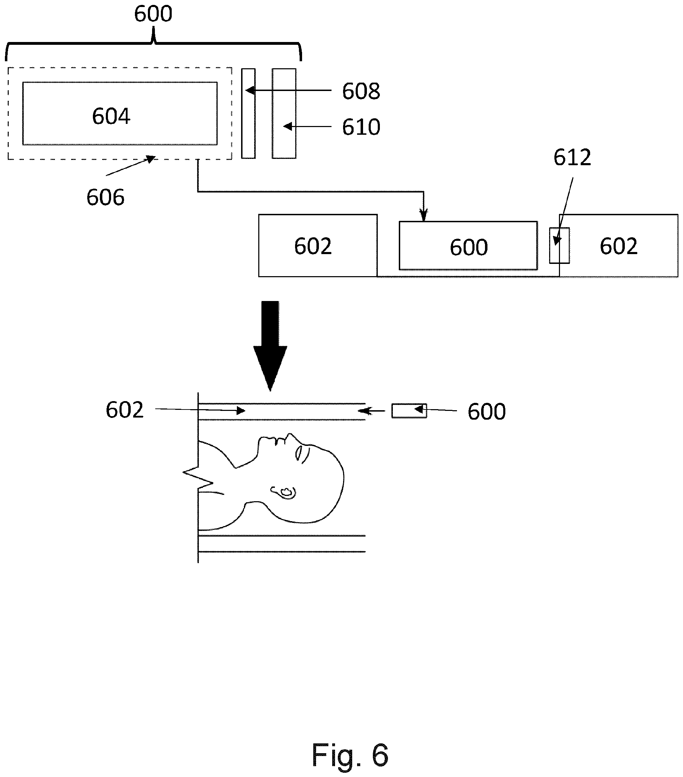

The example of Fig. 1 further depicts switches 126 configured to switch the at least one phantom-portion specific switchable shielding portion. In the example of Fig. 1, the switches comprise Gallium Nitride Field-Effect Transistors, GaN-FETs. Furthermore, in the example of Fig. 1, 6 GaN-FET-comprising switches are depicted, each configured to switch the corresponding switchable shielding portion 114, 116, 118, 120, 122 and 124.

The example phantom 100 in Fig. 1 is a portable phantom 100 that further comprises a mounting mechanism configured to mount the phantom at a specific location relative to a magnetic resonance imaging system. As the example phantom 100 is a fully external unit, it comprises an integrated control circuit, so that the at phantom-portion specific switchable shielding portions 114, 116, 118, 120, 122 and 124 are configured to be switched between the blocking, resonant state and the transparent, non-resonant state by said control circuit.

In order to be fully portable and in order to power the control circuit, the example phantom 100 of Fig. 1 further comprises elements that are not shown in Fig. 1. These elements are mainly a battery, electronics for inductive energy harvesting as well as a temperature sensor, wherein the battery and the electronics for inductive energy harvesting are configured to power the control circuit. The battery may be a rechargeable lithium-ion battery or a rechargeable lithium polymer battery. The electronics for inductive energy harvesting may harvest energy from the magnetic field of the MRI machine and may recharge the battery and power the control circuit. The temperature sensor may report temperatures in its vicinity, e.g., temperatures of the GaN-FETs or the phantom portions, to the control circuit. The example phantom 100 of Fig. 1 may comprise more than one temperature sensor, e.g., temperature sensors for each individual phantom portion, temperature sensors for each individual shielding portion and/or temperature sensors for each individual switch.

In the example of Fig. 1, the control circuit further comprises means for wireless communication configured to receive signals for switching the at least one phantom-portion specific switchable shielding portion and/or send information about a switching state of the at least one phantom-portion specific switchable shielding portion. In said example, the means for wireless communication comprise a Bluetooth transceiver module.

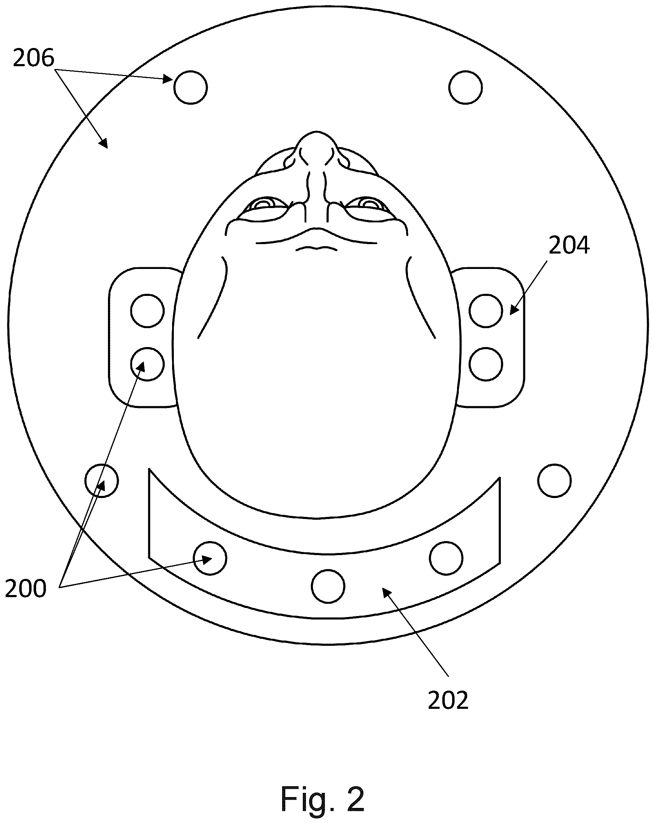

Fig. 2 depicts the MRI phantom 200 integrated into earplugs, a cushion and into a head coil.

In the example of Fig. 2, the MRI phantom 200 is integrated into a cushion 202 configured to support the head of patient to be imaged by an MRI system, into earplugs 204 worn by said patient, as well as into a head coil 206 of an MRI system. In the example of Fig. 2, the head coil 206 of the MRI system comprises a recess configured to accommodate the MRI phantom 200, such that in the example, the MRI phantom 200 is inserted into the recess. The MRI phantom 200 may comprise the mounting mechanism of the example phantom 100 of Fig. 1. In another example not shown in Fig. 2, the MRI phantom 200 may also be fixed permanently to the head coil 206. In the example of Fig. 2, the phantom 200 is permanently integrated into the cushion 202 and the earplugs 204, but it may as well be removable, comprising the mounting mechanism as outlined before.

The phantom in Fig. 2 may be the example phantom of Fig. 1.

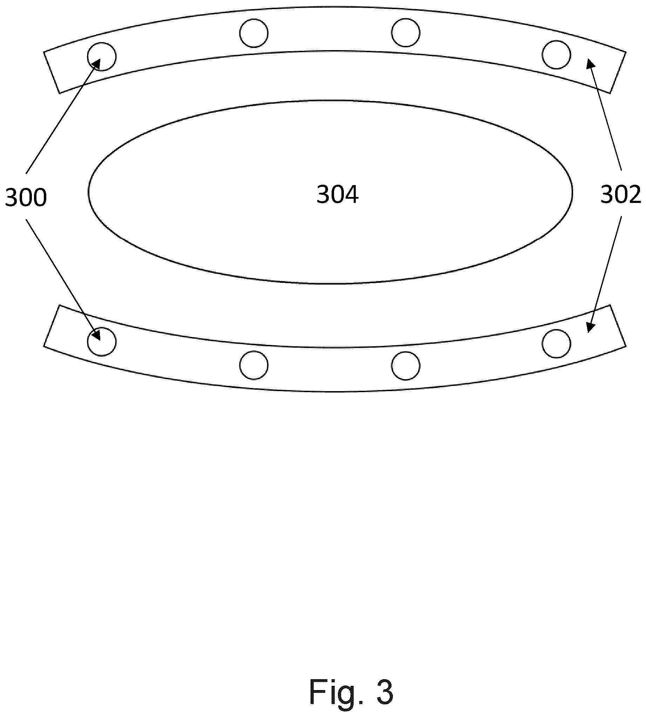

Fig. 3 illustrates flexible surface coils 302 positioned either on top of or beneath the patient's body 304, with the phantoms 300 integrated into the coils.

In Fig. 3, these phantoms 300 could consist of cylindrical containers or other shapes. Additionally, the phantoms 300 might be flexible or partially flexible, featuring integrated switchable shielding to ensure mechanical compatibility with the flexible coils. In the example of Fig. 3, the phantoms 300 may be integrated fixedly and/or removably, e.g., by using abovementioned mounting mechanism.

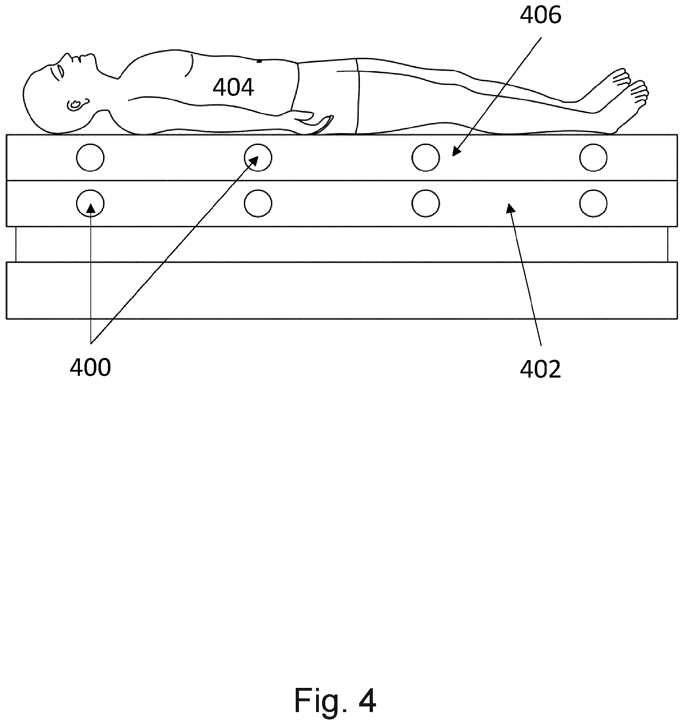

Fig. 4 shows the phantom 400 integrated into an MRI patient's bed 402.

The example of Fig. 4 illustrates a patient's body 404 lying on the patient bed 402, which may be supported by a bridge section. Phantoms 400 may be integrated into the patient bed 402 itself, and additional phantoms 400 could be located within bed-integrated coils 406, allowing for enhanced imaging capabilities during the MRI procedure. In the example of Fig. 4, the phantoms 400 may be integrated fixedly and/or removably, e.g., by using abovementioned mounting mechanism.

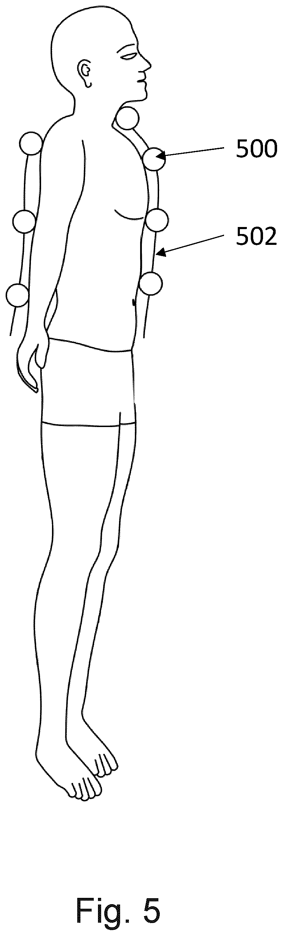

Fig. 5 illustrates phantoms 500 that are integrated into a harness 502.

Fig. 5 illustrates phantoms 500 that could be fixedly and/or removably (with the abovementioned mounting mechanism) integrated into a harness 502, which may be worn by the patient during an MRI imaging procedure. This setup might allow for precise positioning of the phantoms relative to the patient's body, ensuring optimal imaging conditions.

Fig. 6 shows the MRI phantom 600 fitted into a recess of a coil 602.

Fig. 6 illustrates a coil 602 with holes or recesses designed to accommodate the phantom 600. As shown in Fig. 6, the phantom 600 could comprise of a unit that includes a phantom portion 604, a switchable shielding portion 606, an integrated control circuit 608, and additional sensors 610, such as temperature sensors 610. This unit may be equipped with a connector 612, allowing it to be easily placed into a recess or hole, as depicted in Fig. 6.

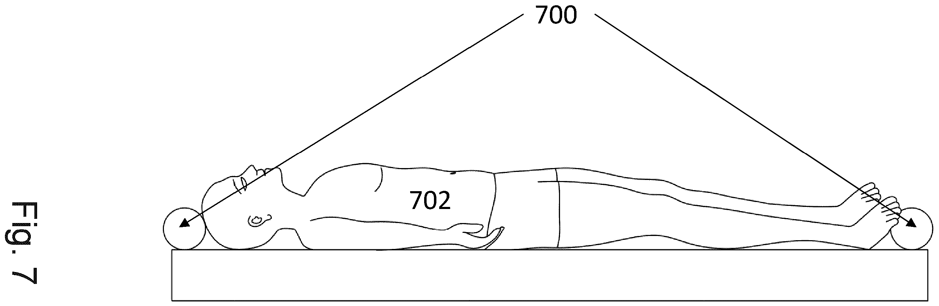

Fig. 7 shows the MRI phantoms 700 fitted into flexible cushions.

In Fig. 7, the MRI phantoms 700 are fitted into flexible cushions. They may be integrated or may designed so that they can be removed. They may be removable by comprising the mounting mechanism as outlined before. The cushions may stabilize the patient's body 702 at various locations.

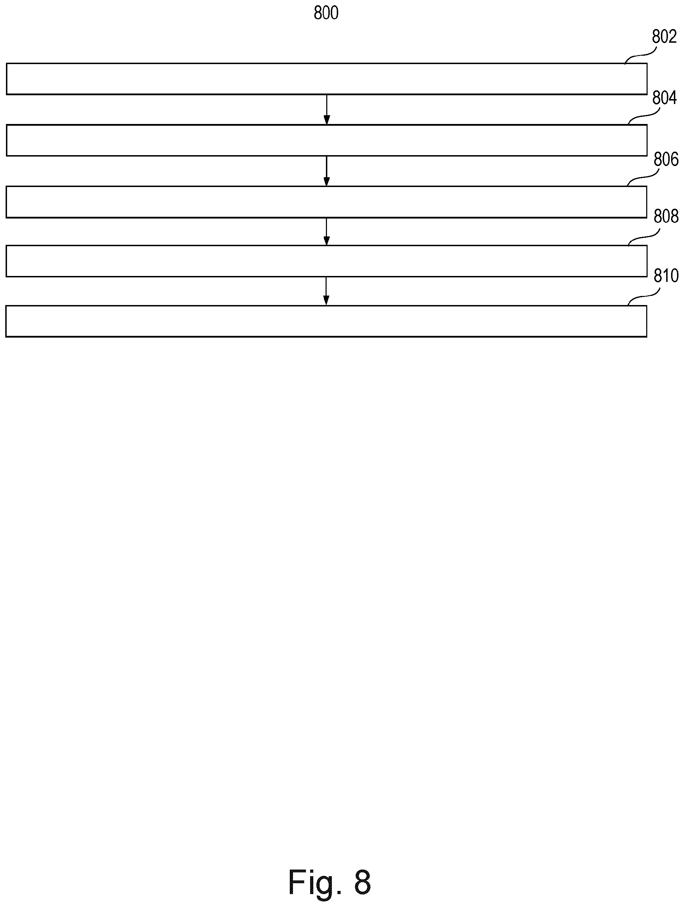

Fig. 8 shows a flowchart for a method for operating an MRI system.

The method of Fig. 8 comprises, in block 802, switching the at least one phantom-portion specific switchable shielding portion to the transparent, non-resonant state. In block 804, it comprises acquiring calibration k space data by controlling the MRI system with at least one calibration pulse sequence command. In block 806, it comprises switching the at least one phantom-portion specific switchable shielding portion to the blocking, resonant state. In block 808, it comprises acquiring imaging k space data by controlling the MRI system with at least one imaging pulse sequence command. In block 810, it comprises reconstructing an MRI image using the imaging k space data and the calibration k space data.

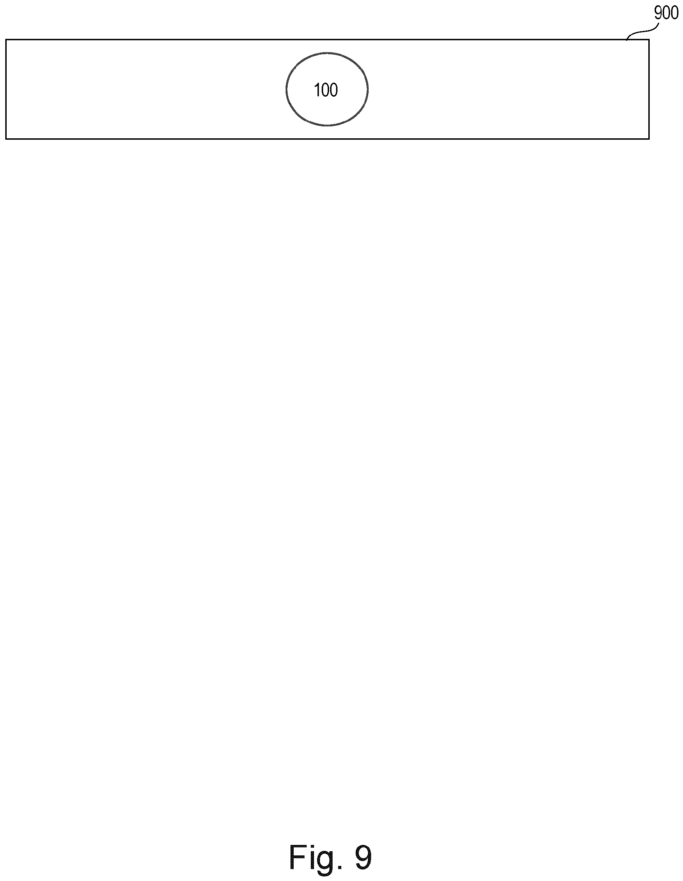

Fig. 9 shows an MRI system 900 comprising the MRI phantom 100.

While the invention has been illustrated and described in detail in the drawings and foregoing description, such illustration and description are to be considered illustrative or exemplary and not restrictive; the invention is not limited to the disclosed examples.

As will be appreciated by one skilled in the art, aspects of the present invention may be embodied as an apparatus, method, computer program or computer program product. Accordingly, aspects of the present invention may take the form of an entirely hardware embodiment, an entirely software embodiment (including firmware, resident software, micro-code, etc.) or an embodiment combining software and hardware aspects that may all generally be referred to herein as a "circuit," "module" or "system." Furthermore, aspects of the present invention may take the form of a computer program product embodied in one or more computer readable medium(s) having computer executable code embodied thereon. A computer program comprises the computer executable code or "program instructions".

Any combination of one or more computer readable medium(s) may be utilized. The computer readable medium may be a computer readable signal medium or a computer readable storage medium. A `computer-readable storage medium' as used herein encompasses any tangible storage medium which may store instructions which are executable by a processor of a computing device. The computer-readable storage medium may be referred to as a computer-readable non-transitory storage medium. The computer-readable storage medium may also be referred to as a tangible computer readable medium. In some embodiments, a computer-readable storage medium may also be able to store data which is able to be accessed by the processor of the computing device. Examples of computer-readable storage media include, but are not limited to: a floppy disk, a magnetic hard disk drive, a solid state hard disk, flash memory, a USB thumb drive, Random Access Memory (RAM), Read Only Memory (ROM), an optical disk, a magneto-optical disk, and the register file of the processor. Examples of optical disks include Compact Disks (CD) and Digital Versatile Disks (DVD), for example CD-ROM, CD-RW, CD-R, DVD-ROM, DVD-RW, or DVD-R disks. The term computer readable-storage medium also refers to various types of recording media capable of being accessed by the computer device via a network or communication link. For example a data may be retrieved over a modem, over the internet, or over a local area network. Computer executable code embodied on a computer readable medium may be transmitted using any appropriate medium, including but not limited to wireless, wireline, optical fiber cable, RF, etc., or any suitable combination of the foregoing.

A computer readable signal medium may include a propagated data signal with computer executable code embodied therein, for example, in baseband or as part of a carrier wave. Such a propagated signal may take any of a variety of forms, including, but not limited to, electro-magnetic, optical, or any suitable combination thereof. A computer readable signal medium may be any computer readable medium that is not a computer readable storage medium and that can communicate, propagate, or transport a program for use by or in connection with an instruction execution system, apparatus, or device.

`Computer memory' or 'memory' is an example of a computer-readable storage medium. Computer memory is any memory which is directly accessible to a processor. `Computer storage' or 'storage' is a further example of a computer-readable storage medium. Computer storage is any nonvolatile computer-readable storage medium. In some embodiments computer storage may also be computer memory or vice versa.

A 'processor' as used herein encompasses an electronic component which is able to execute a program or machine executable instruction or computer executable code. References to the computing device comprising "a processor" should be interpreted as possibly containing more than one processor or processing core. The processor may for instance be a multi-core processor. A processor may also refer to a collection of processors within a single computer system or distributed amongst multiple computer systems. The term computing device should also be interpreted to possibly refer to a collection or network of computing devices each comprising a processor or processors. The computer executable code may be executed by multiple processors that may be within the same computing device or which may even be distributed across multiple computing devices.

Computer executable code may comprise machine executable instructions or a program which causes a processor to perform an aspect of the present invention. Computer executable code for carrying out operations for aspects of the present invention may be written in any combination of one or more programming languages, including an object oriented programming language such as Java, Smalltalk, C++ or the like and conventional procedural programming languages, such as the "C" programming language or similar programming languages and compiled into machine executable instructions. In some instances the computer executable code may be in the form of a high level language or in a pre-compiled form and be used in conjunction with an interpreter which generates the machine executable instructions on the fly.

The computer executable code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider).

Generally, the program instructions can be executed on one processor or on several processors. In the case of multiple processors, they can be distributed over several different entities like clients, servers etc. Each processor could execute a portion of the instructions intended for that entity. Thus, when referring to a system or process involving multiple entities, the computer program or program instructions are understood to be adapted to be executed by a processor associated or related to the respective entity.

Aspects of the present invention are described with reference to flowchart illustrations and/or block diagrams of methods, apparatus (systems) and computer program products according to embodiments of the invention. It will be understood that each block or a portion of the blocks of the flowchart, illustrations, and/or block diagrams, can be implemented by computer program instructions in form of computer executable code when applicable. It is further under stood that, when not mutually exclusive, combinations of blocks in different flowcharts, illustrations, and/or block diagrams may be combined. These computer program instructions may be provided to a processor of a general purpose computer, special purpose computer, or other programmable data processing apparatus to produce a machine, such that the instructions, which execute via the processor of the computer or other programmable data processing apparatus, create means for implementing the functions/acts specified in the flowchart and/or block diagram block or blocks.

These computer program instructions may also be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or block diagram block or blocks.

The computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in the flowchart and/or block diagram block or blocks.

### REFERENCE SIGNS LIST

- 100: MRI phantom
- 102: Phantom portion
- 104: Phantom portion
- 106: Phantom portion
- 108: Phantom portion
- 110: Phantom portion
- 112: Phantom portion
- 114: Switchable shielding portion
- 116: Switchable shielding portion
- 118: Switchable shielding portion
- 120: Switchable shielding portion
- 122: Switchable shielding portion
- 124: Switchable shielding portion
- 126: Switch for switchable shielding portion
- 200: MRI phantom integrated into earplugs, cushion, and head coil
- 202: Cushion for head support
- 204: Earplugs
- 206: Head coil with a recess for MRI phantom
- 300: Phantoms integrated into flexible surface coils
- 302: Flexible surface coil
- 304: Patient's body
- 400: Phantom integrated into MRI patient's bed
- 402: MRI patient's bed
- 404: Patient's body lying on the bed
- 406: Bed-integrated coils
- 500: Phantom integrated into a harness
- 502: Harness worn by the patient
- 600: MRI phantom fitted into a recess of a coil
- 602: Coil with recesses for accommodating the phantom
- 604: Phantom portion
- 606: Switchable shielding portion
- 608: Integrated control circuit
- 610: Temperature sensor
- 612: Connector
- 700: MRI phantoms fitted into flexible cushions
- 702: Patient's body stabilized by cushions
- 900: MRI system

## Claims

1. A magnetic resonance imaging, MRI, phantom (100, 200, 300, 400, 500, 700), the magnetic resonance imaging phantom (100, 200, 300, 400, 500, 700) comprising:
at least one phantom portion (102, 104, 106, 108, 110, 112, 604); and
at least one phantom-portion specific switchable shielding portion (114, 116, 118, 120, 122, 124, 606), wherein the at least one switchable shielding portion is configured to be switchable between a blocking, resonant state and a transparent, non-resonant state respective to an MRI frequency range.

2. The MRI phantom (100, 200, 300, 400, 500, 700) of claim 1, wherein the at least one phantom-portion specific switchable shielding portion (114, 116, 118, 120, 122, 124, 606) is configured to be switched between the blocking, resonant state and the transparent, non-resonant state by a control circuit (608), wherein the control circuit is either integrated into the MRI phantom (100, 200, 300, 400, 500, 700) or an external control circuit.

3. The MRI phantom (100, 200, 300, 400, 500, 700) of claim 2, wherein in case the control circuit (608) is integrated into the MRI phantom, the MRI phantom further comprises:
a battery and/or electronics for energy harvesting, in particular electronics for inductive energy harvesting, wherein the battery and/or electronics for energy harvesting are configured to power the control circuit (608);
and wherein the control circuit (608) further comprises:
means for wireless communication configured to receive signals for switching the at least one phantom-portion specific switchable shielding portion (114, 116, 118, 120, 122, 124, 606) and/or send information about a switching state of the at least one phantom-portion specific switchable shielding portion.

4. The MRI phantom (100, 200, 300, 400, 500, 700) of any of the previous claims, comprising at least two of the phantom portions (102, 104, 106, 108, 110, 112, 604), and further comprising at least two of the phantom-portion specific switchable shielding portions (114, 116, 118, 120, 122, 124, 606), wherein the at least two phantom-portion specific switchable shielding portions are configured to be switchable independently from each other.

5. The MRI phantom (100, 200, 300, 400, 500, 700) of any of the previous claims, further comprising at least one sensor, in particular at least one temperature sensor (610).

6. The MRI phantom (100, 200, 300, 400, 500, 700) of any of the previous claims, wherein the MRI phantom further comprises switches (126) configured to switch the at least one phantom-portion specific switchable shielding portion (114, 116, 118, 120, 122, 124, 606), wherein the switches (126) comprise any one of the following: Gallium Nitride Field-Effect Transistors, GaN-FETs, diodes, in particular positive intrinsic negative diodes, Field-Effect Transistors, FETs, and/or Micro-Electro-Mechanical-Systems, MEMs.

7. The MRI phantom (100, 200, 300, 400, 500, 700) of any of the previous claims, wherein the phantom further comprises a mounting mechanism configured to mount the phantom at a specific location relative to a magnetic resonance imaging system.

8. The MRI phantom (100, 200, 300, 400, 500, 700) of any of the previous claims, wherein the MRI phantom is integrated into a cushion (202) configured to support a body or a portion of a body of a patient to be imaged by an MRI system, and/or wherein the MRI phantom is integrated into earplugs (204) and/or a harness configured to be worn by a patient to be imaged by an MRI system and/or wherein the MRI phantom is integrated into a therapy device, wherein in particular the therapy device is any one of the following: an oncology device, a radiactive seed, an electromagnetic or optical therapy unit, wherein the oncology device comprises any one of the following: a Linear Accelerator, Linac, a Brachytherapy Applicator, a Proton Therapy System, an MRI-Guided Focused Ultrasound Therapy device, MRgFUS, a Theranostic System, an Interventional Oncology device.

9. A magnetic resonance imaging, MRI, system (900) comprising the MRI phantom (100, 200, 300, 400, 500, 700) of any of the previous claims.

10. The MRI system (900) of claim 9, wherein the MRI phantom (100, 200, 300, 400, 500, 700) is integrated into a head coil (206), a surface coil, a body coil, and/or a bed-integrated surface coil (406) of the MRI system.

11. The MRI system (900) of any of claims 9-10, wherein at least one coil of the MRI system (900) comprises a recess configured to accommodate the MRI phantom (100, 200, 300, 400, 500, 700), such that the MRI phantom can be inserted into or removed from the recess.

12. A method of operating a magnetic resonance imaging, MRI, phantom (100, 200, 300, 400, 500, 700), the magnetic resonance imaging phantom (100, 200, 300, 400, 500, 700) comprising:
at least one phantom portion (102, 104, 106, 108, 110, 112, 604); and
at least one phantom-portion specific switchable shielding portion (114, 116, 118, 120, 122, 124, 606), wherein the at least one switchable shielding portion is configured to be switchable between a blocking, resonant state and a transparent, non-resonant state respective to an MRI frequency range;
the method comprising:
in response to receiving a switching signal, switching the at least one phantom-portion specific switchable shielding portion (114, 116, 118, 120, 122, 124, 606).

13. The method of claim 12, wherein the switching signal is received from an MRI system (900).

14. A method for operating the MRI system (900) of claim 9, comprising:
switch the at least one phantom-portion specific switchable shielding portion (114, 116, 118, 120, 122, 124, 606) to the transparent, non-resonant state;
acquire calibration k space data by controlling the MRI system with at least one calibration pulse sequence command;
switch the at least one phantom-portion specific switchable shielding portion (114, 116, 118, 120, 122, 124, 606) to the blocking, resonant state;
acquire imaging k space data by controlling the MRI system with at least one imaging pulse sequence command; and
reconstruct an MRI image using the imaging k space data and the calibration k space data.

15. A computer program comprising machine executable instructions for execution by a computational system, wherein execution of the machine executable instructions causes the computational system to perform the method of any of the previous method claims.
